# EUROPEAN PATENT SPECIFICATION

(11) **EP 2 180 329 B1**
(45) Date of publication and mention of the grant of the patent: **24.10.2012**
(21) Application number: 09252116.0
(22) Date of filing: 02.09.2009
(51) Int. Cl.: G01R 33/09, G01R 33/00

(54) **Magnetic sensor apparatus**
Magnetische Sensorvorrichtung
Appareil capteur magnétique

(30) Priority: 02.09.2008 JP 2008224296
(43) Date of publication of application: 28.04.2010
(73) Proprietor: Murata Manufacturing Co., Ltd., Nagaokakyo-shi, Kyoto-fu 617-8555 (JP)
(72) Inventor: Minamidani, Tamotsu, Nagaokakyo-shi, Kyoto-fu 617-8555 (JP)
(74) Representative: Reeve, Nicholas Edward

(56) References cited:
- JP-A- 2006 010 579
- US-A1- 2006 072 249

## Description

The present invention relates to a magnetic sensor apparatus that detects magnetic information, such as magnetic sections provided on a detection subject.

There have been devised various magnetic sensor apparatuses that detect a magnetic section or magnetic information incorporated into a detection subject, such as a bank bill.

For example, Japanese Unexamined Patent Application Publication No. 2002-84015 discloses a typical differential magnetic sensor having a meandering magnetic resistance effect film formed on a substrate. Also, Japanese Unexamined Patent Application Publication No. 2005-37337 discloses a differential magnetic sensor including multiple magnetic resistance elements. More specifically, as shown in Fig. 24 of JP 2005-37337, the magnetic resistance elements each include multiple long-length magnetism-sensing sections and are disposed and connected in series in such a manner that the directions of the long lengths of the magnetism-sensing sections thereof are parallel with one another.

By connecting a voltage divided by coupling the magnetic resistance elements in series as described above, that is, by producing a differential output, the influence of a resistance temperature characteristic where the resistance value varies with the temperature of the magnetic resistance elements is restrained.

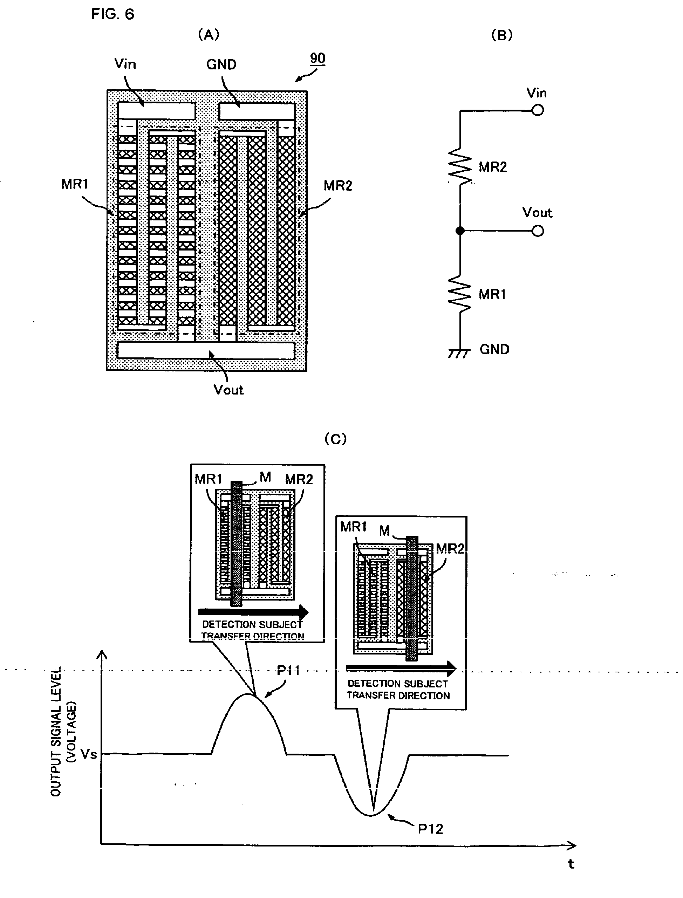

When passing a detection subject having thereon magnetized sections M serving as magnetic sections near a differential magnetic sensor as described above, an output signal as shown in Fig. 6(C) is obtained.

Fig. 6(A) is a drawing showing a schematic configuration of a magnetism detection unit 90 of a related-art magnetic sensor apparatus similar to the magnetic sensor described in the above-mentioned JP 2005-37337. Fig. 6(B) is an equivalent circuit diagram of the magnetism detection unit 90 of the magnetic sensor apparatus shown in Fig. 6(A). Fig. 6(C) is a conceptual drawing showing the detection state of magnetized sections M of a detection subject.

As shown in Figs. 6(A) and 6(B), the magnetism detection unit 90 of the related-art magnetic sensor apparatus has a configuration where magnetic resistance elements MR1 and MR2 are connected in series between a voltage input terminal Vin and a ground terminal GND and where a output voltage terminal Vout is connected to the junction of these magnetic resistance elements. The magnetic resistance elements MR1 and MR2 each include multiple long-length magnetism-sensing sections, the resistance value of each of which varies with variations in the magnetic flux density due to the passage of a magnetized section M. The magnetic resistance elements MR1 and MR2 are disposed in positions separated in the direction of transfer of the detection subject.

When transferring the detection subject over a surface of the magnetism detection unit 90 having such a configuration, first, the magnetic section M passes over the magnetic resistance element MR1 and then passes over the magnetic resistance element MR2. In this case, as shown in Fig. 6(C), the magnetic resistance element MR1 and MR2 detects a high peak P11 and a low peak P12, relatively, that occur when a normal voltage value Vs varies with variations in magnetic flux density due to the passage of the magnetic section M.

However, if the above-mentioned magnetized sections M are provided continuously along the transfer direction, the following problems occur.

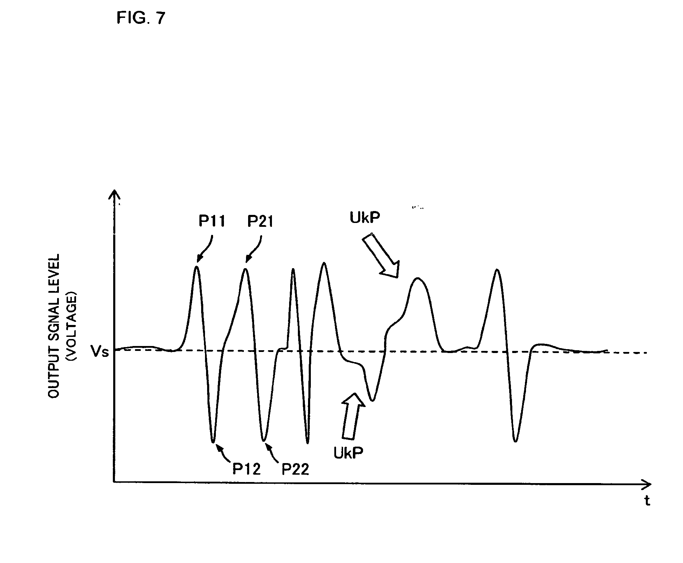

Fig. 7 is a diagram showing a waveform representing output signal levels obtained when detecting multiple magnetic sections of a detection subject formed in the transfer direction.

As shown in Fig. 7, when detecting the multiple magnetic sections disposed on the detection subject at intervals while transferring the detection subject, high peaks (P11 and P21) and low peaks (P12 and P22), whose level or width depends on the individual magnetized sections, may appear. On the other hand, voltage variations that cannot be considered as clear peaks, as shown by UkP areas in the diagram, may also appear. Such a voltage variation appears, for example, in a case where at approximately the same time that one magnetized section passes over the magnetic resistance element MR1, another magnetized section passes over the magnetic resistance element MR2 or in a case where while the magnetic resistance element MR1 senses a variation in the magnetic flux density due to the passage of one magnetized section, the magnetic resistance element MR2 senses a variation in the magnetic flux density due to the passage of another magnetized section.

If such ambiguous peaks appear, a magnetic arrangement pattern formed by the multiple magnetized sections provided on the detection subject cannot be detected accurately.

Accordingly, we have appreciated that there is a need for a magnetic sensor apparatus that, even if multiple magnetized sections are arranged on a detection subject, is allowed to output a simple waveform with respect to each magnetized section so as to detect each magnetized section accurately.

### Summary of the invention

The invention is defined in the independent claims to which reference should now be made. Advantageous features are set forth in the dependent claims.

A magnetic sensor apparatus according to an embodiment of the present invention includes a plurality of magnetism detection units connected in parallel between a voltage input terminal and a ground terminal. Each magnetism detection unit includes a plurality of magnetic resistance elements and resistance elements In series connected between the voltage input terminal and the ground terminal. Each magnetism detection unit outputs a voltage, which is obtained due to voltage division performed by the magnetic resistance elements and resistance elements, from an output voltage terminal connected to a junction of the magnetic resistance elements and resistance elements as an output voltage. Each magnetic resistance element includes a plurality of long-length magnetism-sensing sections disposed on a surface of a substrate Each magnetism-sensing section is a magnetism-sensing section, a resistance value of which varies due to passage of a magnetic flux. The magnetism-sensing sections have different characteristics with respect to a variation In resistance value due to passage of a magnetic flux. The magnetism-sensing sections of all the magnetic resistance elements are arranged side by side in one direction so that at least one magnetism-sensing section included in one magnetic resistance element is not adjacent to any side of each of the plurality of other magnetism-sensing sections included in the magnetic resistance element. The magnetic sensor apparatus also includes a differential amplifier circuit receiving output signals of the magnetism detection units to perform a differential amplification process.

In this configuration, the multiple magnetic resistance elements included in each magnetism detection unit have different sensitivities. That is, one magnetic resistance element has more sensitive magnetism-sensing sections than those of another magnetic resistance element. A waveform representing voltages outputted by each magnetism detection unit with respect to a magnetized section of a detection subject is a waveform where the influence of the less sensitive magnetism-sensing sections is cancelled out and which has one peak.

In this case, the magnetism-sensing sections of each magnetic resistance element have long lengths. Also, the multiple magnetism-sensing sections of each magnetic resistance element are not gathered. Also, the magnetism-sensing sections of the magnetic resistance elements are disposed in such a manner that the magnetic resistance elements change places one after another along a direction perpendicular to the directions of the long lengths. Therefore, the multiple magnetism detection units almost simultaneously output voltage signals with respect to one magnetized section.

By differentially amplifying the voltage signals outputted by the magnetism detection units almost simultaneously, a clearer peak appears with respect to each magnetized section without changing the number of peaks and the peak appearance timing.

In the magnetic sensor apparatus according to the embodiment of the present invention, directions of the long lengths of the magnetism-sensing sections are preferably perpendicular to a direction of arrangement of magnetized sections of a detection subject.

By adopting this configuration, a variation in the magnetic flux density due to the passage of each magnetized section is simultaneously detected by the magnetic resistance elements included in the magnetism detection units. Therefore, the timings when the magnetism detection units output voltage signals are matched more accurately. Thus, the magnetized sections are detected accurately.

In the magnetic sensor apparatus according to the embodiment of the present invention, a plurality of magnetism-sensing sections included in each of the magnetic resistance elements, a resistance value of each of which significantly varies due to passage of a magnetic flux, among the magnetic resistance elements are disposed in such a manner that directions of the long lengths thereof are parallel with one another and in such a manner that at least one magnetism-sensing section included in one of the magnetic resistance elements is not adjacent to any side of each of the plurality of other magnetism-sensing sections included in the magnetic resistance element. Also, one of the sensitive magnetic resistance elements is connected between the output voltage terminal and the ground terminal in a first magnetic detection unit of the magnetic detection units, and one of the magnetic resistance elements is preferably connected between the voltage input terminal and the output voltage terminal in a second magnetic detection unit thereof.

By adopting this configuration, output voltage signals, in each of which a peak appears at an almost identical timing relative to a reference level, which is a normal voltage at a time when no magnetism is sensed by the magnetic detection units, and that have opposite polarities are obtained as an output voltage signal of the first magnetism detection unit and an output voltage signal of the second magnetism detection unit. By differentially amplifying the two output voltage signals as they are, a voltage signal having one peak at a higher level is obtained with respect to one magnetized section. Thus, the magnetized sections are detected more accurately.

In the magnetic sensor apparatus according to the embodiment of the present invention, a plurality of magnetism-sensing sections included in each of resistance elements among the plurality of elements included in the first magnetic detection unit are disposed along with magnetism-sensing sections of the magnetic resistance elements among the magnetic resistance elements included in the first magnetic detection unit In such a manner that at least one magnetism-sensing section included in one of the resistance elements is not adjacent to any side of each of the plurality of other magnetism-sensing sections included in the resistance element

By adopting this configuration, all the magnetism-sensing sections of the multiple magnetic resistance elements included in one magnetism detection unit, including not only the magnetism-sensing sections of the magnetic resistance elements but also those of the resistance elements, are disposed, without being gathered for each corresponding magnetic resistance element, in such a manner that the magnetic resistance elements change places one after another along a direction perpendicular to the directions of the long,lengths. Therefore, the timings when the multiple magnetism detection units output voltage signals with respect to one magnetized section are nearly matched. Thus, in each magnetism detection unit, the magnetic resistance elements including sensitive magnetism-sensing sections and the resistance elements including less sensitive magnetism-sensing sections output voltage signals simultaneously. As a result, the influence of the less sensitive magnetism-sensing sections is accurately cancelled out by the voltage signals outputted by the sensitive magnetism-sensing sections. By using the output voltage signal where the influence of the less sensitive magnetism-sensing sections has been cancelled out as described above, the timings when the multiple magnetism detection units output voltage signals with respect to one magnetized section are matched more accurately, Thus, the magnetized sections are detected more accurately.

By adopting the embodimentof the present invention, an output voltage waveform having only one peak is obtained with respect to each of the magnetized sections of the detection subject. Thus, even when transferring a detection subject having multiple magnetized sections formed thereon so as to pass the magnetized section near the detection area of a magnetic sensor apparatus one after another, it is possible to detect the magnetized sections individually while accurately detecting the width or magnetism thereof.

### Brief Description of the Drawings

Fig. 1 includes an equivalent circuit diagram showing a configuration of a magnetic sensor apparatus 1 according to a first embodiment of the present invention and a plan view showing a configuration of a magnetic detection circuit 10 of the magnetic sensor apparatus 1.
Fig. 2 includes a diagram showing the waveform and operation of an output voltage signal of the magnetic detection circuit 10 according to the first embodiment and a diagram showing the waveform of an output voltage signal of the magnetic sensor apparatus 1.
Fig. 3 includes a plan view showing a configuration of a magnetic detection circuit 20 of a magnetic sensor apparatus according to a second embodiment of the present invention and an equivalent circuit diagram showing the magnetic detection circuit 20.
Fig. 4 includes a diagram showing the waveform and operation of an output voltage signal of the magnetic detection circuit 20 according to the second embodiment and a diagram showing the waveform of an output voltage signal of a magnetic sensor apparatus including the magnetic detection circuit 20.
Fig. 5 includes a plan view showing a configuration of a magnetic detection circuit 30 according to a third embodiment of the present invention and an equivalent circuit diagram showing the magnetic detection circuit 30.
Fig. 6 includes a drawing showing a schematic configuration of a related-art magnetic sensor, an equivalent circuit diagram showing a magnetic sensor apparatus 90, and a conceptual drawing showing the detection state of magnetized section M of a detection subject.
Fig. 7 is a diagram showing a waveform representing output signal levels obtained when detecting multiple magnetized sections of a detection subject formed in the transfer direction.

### Detailed Description of the Preferred Embodiment

Now, a magnetic sensor apparatus according to a first embodiment of the present invention will be described with reference to the accompanying drawings.

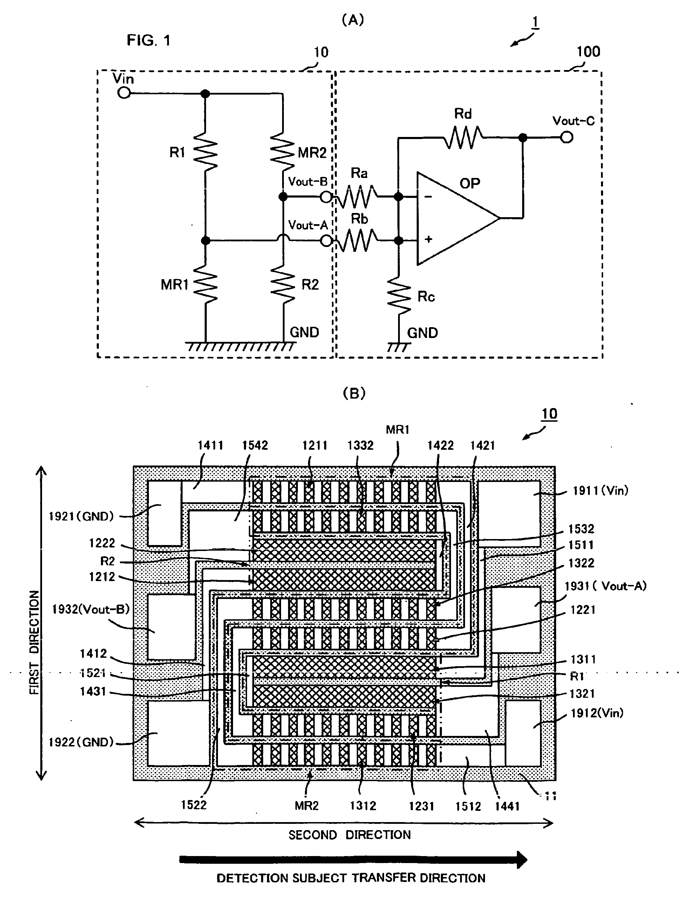

Fig. 1(A) is an equivalent circuit diagram showing a configuration of a magnetic sensor apparatus 1 according to this embodiment. Fig. 1(B) is a plan view showing a configuration of a magnetic detection circuit 10 of the magnetic sensor apparatus 1 shown in Fig. 1 (A).

The magnetic sensor apparatus 1 includes the magnetic detection circuit 10 and a differential amplifier circuit 100.

The magnetic detection circuit 10 has a voltage input terminal Vin, a ground terminal GND, and two output voltage terminals Vout-A and Vout-B. A series circuit including resistance element R1 and magnetic resistance element MR1 and a series circuit including magnetic resistance element MR2 and resistance element R2 are connected between the voltage input terminal Vin and ground terminal GND. As for the series circuit including the resistance element R1 and magnetic resistance element MR1, the resistance element R1 is connected to the voltage input terminal Vin and the magnetic resistance element MR1 is connected to the ground terminal GND. As for the series circuit including the magnetic resistance element MR2 and resistance element R2, the magnetic resistance element MR2 is connected to the voltage input terminal Vin and the resistance element R2 is connected to the ground terminal GND. The output voltage terminal Vout-A is connected to the junction of the resistance element R1 and magnetic resistance element MR1. The output voltage terminal Vout-B is connected to the junction of the magnetic resistance element MR2 and resistance element R2.

Two voltage input electrodes 1911 and 1912 corresponding to the voltage input terminal Vin and a single voltage output electrode 1931 corresponding to the output voltage terminal Vout-A are disposed at one end of a magnetic detection circuit 10 formation area in a second direction (detection subject transfer direction) on a substrate 11 made of e.g., an Si substrate. Two ground connection electrodes 1921 and 1922 corresponding to the ground terminal GND and a single voltage output electrode 1932 corresponding to the output voltage terminal Vout-B are disposed at the other end thereof. The voltage input electrodes 1911 and 1922, ground connection electrodes 1921 and 1922, and voltage output electrodes 1931 and 1932 are made of a conductive material.

Disposed on the substrate 11 are magnetism-sensing sections 1211, 1221, and 1231 and connection line electrodes 1411, 1421, 1431, and 1441 included in the magnetic resistance element MR1, magnetism-sensing sections 1312, 1322, and 1332 and connection line electrodes 1512, 1522, 1532, and 1542 included in the magnetic resistance element MR2, magnetism-sensing sections 1311 and 1321 and connection line electrodes 1511 and 1521 and 1441 included in the resistance element R1, and magnetism-sensing sections 1212 and 1222 and connection line electrodes 1412, 1422, and 1542 included in the resistance element R2. In this case, the connection line electrode 1441 connected to the voltage output electrode 1931 is commonly used by the magnetic resistance element MR1 and resistance element R1. The connection line electrode 1542 connected to the voltage output electrode 1932 is commonly used by the magnetic resistance element MR2 and resistance element R2.

The magnetism-sensing sections 1211, 1221, 1231, 1312, 1322, and 1332 included in the magnetic resistance elements MR1 and MR2 each include a semiconductor film made of a semiconductor, such as InSb, the resistance value of which varies due to passage of a magnetic flux, and are formed in a long-length pattern where the length is larger than the width. The magnetism-sensing sections 1211, 1221, 1231, 1312, 1322, and 1332 are each formed by forming multiple shorting circuits made of a conductive material along the long length at predetermined intervals on the semiconductor film made of InSb or the like. On the basis of the pattern formed by these shorting electrodes, the sensitivity with respect to the magnetic flux density, that is, the ratio at which the resistance value varies with a variation in magnetic flux is set. The magnetism-sensing sections 1211, 1221, 1231, 1312, 1322, and 1332 are disposed in such a manner that the long length directions thereof are parallel with the second direction.

The magnetism-sensing section 1211 included in the magnetic resistance element MR1 and the ground connection electrode 1921 are electrically connected via the connection line electrode 1411. Also, in the magnetic resistance element MR1, the magnetism-sensing sections 1211 and 1221 are electrically connected via the connection line electrode 1421 and the magnetism-sensing sections 1221 and 1231 are electrically connected via the connection line electrode 1431. Also, the magnetism-sensing section 1231 included in the magnetic resistance element MR1 and the voltage output electrode 1931 are electrically connected via the connection line electrode 1441.

The magnetism-sensing section 1312 included in the magnetic resistance element MR2 and the voltage input electrode 1912 are electrically connected via the connection line electrode 1512. Also, in the magnetic resistance element MR2, the magnetism-sensing sections 1312 and 1322 are electrically connected via the connection line electrode 1522 and the magnetism-sensing sections 1322 and 1332 are electrically connected via the connection line electrode 1532. Also, the magnetism-sensing section 1332 included in the magnetic resistance element MR2 and the voltage output electrode 1932 are electrically connected via the connection line electrode 1542.

Magnetism-sensing sections 1311, 1321, 1212, and 1222 are included in the resistance elements R1 and R2, and each include a semiconductor film made of a semiconductor, such as InSb, the resistance value of which varies due to passage of a magnetic flux. Each of R1 and R2 are formed in a long-length pattern where the length is larger than the width. Unlike the magnetic resistance elements MR1 and MR2, no shorting electrodes are formed on the semiconductor films forming the magnetism-sensing sections 1311, 1321, 1212, and 1222 of the resistance element R1 and R2 so that the resistance value hardly varies with variations in the magnetic flux density. The magnetism-sensing sections 1311, 1321, 1212, and 1222 are also disposed in such a manner that the long length directions thereof are parallel with the second direction.

The magnetism-sensing section 1311 included in the resistance element R1 and the voltage input electrode 1911 are electrically connected via the connection line electrode 1511. Also, in the resistance element R1, the magnetism-sensing sections 1311 and 1321 are electrically connected via the connection line electrode 1521. Also, the magnetism-sensing section 1321 included in the resistance element R1 and voltage output electrode 1931 are electrically connected via the connection line electrode 1441.

The magnetism-sensing section 1212 included In the resistance element R2 and the ground connection electrode 1922 are electrically connected via the connection line electrode 1412. Also, in the resistance element R2, The magnetism-sensing sections 1212 and 1222 are electrically connected via the connection line electrode 1422. Also, the magnetism-sensing section 1222 included in the resistance element R2 and the voltage output electrode 1932 are electrically connected via the connection line electrode 1542.

The magnetism-sensing sections included in the magnetic resistance elements MR1 and MR2, and resistance elements R1 and R2, are closely arranged in the following order along a first direction of the formation area of the magnetic detection circuit 10. That is, the magnetism-sensing section 1211 of the magnetic resistance element MR1, the magnetism-sensing section 1332 of the magnetic resistance element MR2, the magnetism-sensing sections 1222 and 1212 of the resistance element R2, the magnetism-sensing section 1322 of the resistance element MR2, the magnetism-sensing section 1221 of the magnetic resistance element MR1, the magnetism-sensing sections 1311 and 1321 of the resistance element R1, the magnetism-sensing section 1231 of the magnetic resistance element MR1, and the magnetism-sensing section 1312 of the magnetic resistance element MR2 are disposed in the presented order from a first end (upper end of Fig. 1 (B)) of the first direction.

Thus, the magnetism-sensing sections of the magnetic resistance elements MR1 and MR2, and resistance elements R1 and R2, are configured in a convoluted manner without the magnetism-sensing sections of each magnetic resistance element being gathered. Also, since the magnetism-sensing sections of the magnetic resistance elements MR1 and MR2 and resistance elements R1 and R2, are arranged along the first direction perpendicular to the detection subject transfer direction, the magnetic resistance elements MR1 and MR2, and resistance elements R1 and R2, react to the passage of the magnetized sections provided on the detection subject simultaneously.

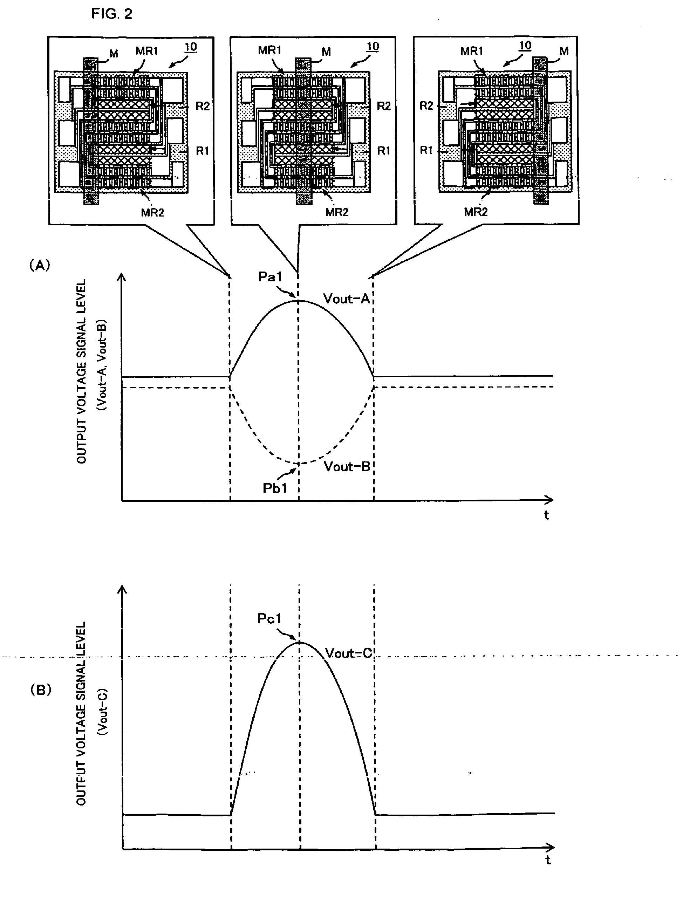

Fig. 2(A) is a diagram showing the waveform and operation of an output voltage signal of the magnetic detection circuit 10 according to this embodiment. Fig. 2(B) is a diagram showing the waveform of an output voltage signal of the magnetic sensor apparatus 1. M in Fig. 2 represents a magnetized section of a detection subject.

By adopting the above-mentioned material and configuration of the magnetism-sensing sections, the magnetic resistance element MR1 has a characteristic where the resistance value thereof is increased to a greater extent than that of the resistance element R1 as the magnetic flux density is increased. Also, since the magnetic resistance element MR1 is connected to the ground terminal GND, the output voltage signal Vout-A take a waveform where as the magnetized section M of the detection subject passes by the magnetic resistance element MR1 and resistance element R1, the voltage level increases gradually, then reaches a predetermined first peak value Pa1, and then decreases gradually on the basis of the voltage division ratio between these magnetic resistance elements. In this case, the magnetic resistance element MR1 and resistance element R1 react to variations in magnetic flux density simultaneously, and variations in level of a voltage outputted by the resistance element R1 are significantly smaller than variations in level of a voltage outputted by the magnetic resistance element MR1. Therefore, variations in level of a voltage outputted by the resistance element R1 are cancelled out by variations in level of a voltage outputted by the magnetic resistance element MR1, since the former are errors or so compared with the latter.

On the other hand, the magnetic resistance element MR2 has a characteristic where the resistance value thereof is increased to a greater extent than that of the resistance element R2 as the magnetic flux density is increased. Also, since the magnetic resistance element MR2 is connected to the voltage input terminal Vin, the output voltage signal Vout-B takes a waveform where as the magnetized section M of the detection subject passes by the magnetic resistance element MR2 and resistance element R2, the voltage level decreases gradually, then reaches a predetermined second peak value Pb1, and then increases gradually on the basis of the voltage division ratio between these magnetic resistance elements. In this case, the magnetic resistance element MR2 and resistance element R2 simultaneously react to variations in magnetic flux density and variations in level of a voltage outputted by the resistance element R2 are significantly smaller than variations in level of a voltage outputted by the resistance element MR2. Therefore, variations in level of a voltage outputted by the resistance element R2 are cancelled out by variations in level of a voltage outputted by the magnetic resistance element MR2, since the former are errors or so compared with the latter.

Also in this case, the magnetism-sensing sections of the magnetic resistance element MR1 and resistance element R1 and the magnetism-sensing sections of the magnetic resistance element MR2 and resistance element R2 are formed in an approximately identical area on the formation area of the magnetic detection circuit 10.

Thus, the magnetic resistance elements MR1 and MR2, and resistance element R1 and R2, react to vibrations in the magnetic flux density simultaneously. Therefore, the output voltage signal Vout-A and output voltage signal Vout-B also react to the variations in magnetic flux density simultaneously. In other words, the start timing of voltage level variations due to variations in the magnetic flux density, the timing of reaching a peak value, the end timing of the variations, and the like of the output voltage signal Vout-A and those of the output voltage signal Vout-B area matched on a time base.

The output voltage signals Vout-A and Vout-B generated in this way are inputted into the differential amplifier circuit 100.

The differential amplifier circuit 100 includes an operational amplifier OP. The above-mentioned output voltage terminal Vout-B is connected to an inverted input terminal of the operational amplifier OP via a resistance Ra. The above-mentioned output voltage terminal Vout-A is connected to a non-inverted input terminal thereof via a resistance Rb. Also, the non-inverted input terminal of the operational amplifier OP is connected to the ground via a resistance Rc, and an output terminal Vout-C thereof is connected to the inverted input terminal thereof via a resistance Rd. The resistances Ra and RB have an identical resistance value. The resistances Rc and Rd have an identical resistance value. The resistance values of the resistances Rc and Rd are set to predetermined multiples (for example, ten times or so) of the resistance value of the resistances Ra and Rb.

The differential amplifier circuit 100 differentially amplifies output voltage signals Vout-A and Vout-B received from the magnetic detection circuit 10 so as to generate an output voltage signal Vout-C. By adopting the above-mentioned configuration, the output voltage signals Vout-A and Vout-B, which are input signals of the differential amplifier circuit 100, are in synchronization with each other. Also, if a voltage level in a state where no magnetism is sensed is used as a reference, the output voltage signals Vout-A and Vout-B have opposite voltage characteristics.

For this reason, as the magnetic flux density varies, the voltage level of the output voltage signal Vout-C varies to a greater extent than those of the output voltage signals Vout-A and Vout-B. Also, the output voltage signal Vout-C is a signal having levels higher than a voltage level (offset voltage level) during a period when no magnetism is sensed. Thus, the magnetized section of the detection subject is detected reliably and accurately. In this case, a waveform having one peak is obtained with respect to one magnetized section. Therefore, even if multiple magnetized sections are arranged, each magnetized section is detected accurately.

Next, a magnetic sensor apparatus according to a second embodiment of the present invention will be described with reference to the drawings.

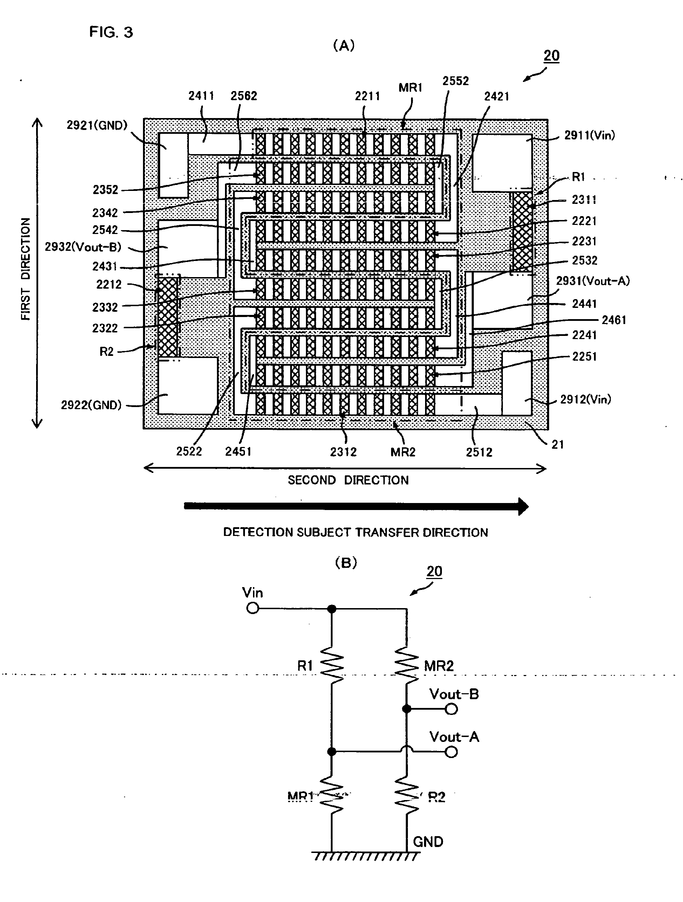

Fig. 3(A) is a plan view showing a configuration of a magnetic detection circuit 20 of the magnetic sensor apparatus according to this embodiment. Fig. 3(B) is an equivalent circuit diagram showing the magnetic detection circuit 20 shown in Fig. 3(A).

The magnetic sensor apparatus according to this embodiment is different from the first embodiment in only the configuration of the magnetic detection circuit 20. For this reason, only the configuration of the magnetic detection circuit 20 will be described.

As shown in Fig. 3(B), as with the magnetic detection circuit 10 according to the first embodiment, the magnetic detection circuit 20 according to this embodiment is a circuit formed by forming magnetism-sensing sections and conductive electrodes on a substrate 21. This embodiment is also the same as the first embodiment with respect to the materials of the substrate 21, magnetism-sensing sections, and conductive electrodes.

Two voltage input electrodes 2911 and 2912 corresponding to the voltage input terminal Vin and a single voltage output electrode 2931 corresponding to the output voltage terminal Vout-A are disposed at one end of the formation area of the magnetic detection circuit 20 on a substrate 21 along a second direction (detection subject transfer direction). Two ground connection electrodes 2921 and 2922 corresponding to the ground terminal GND voltage and a single voltage output electrode 2932 corresponding to the output voltage terminal Vout-B are disposed at the other end thereof.

Also disposed on the substrate 21 are magnetism-sensing sections 2211, 2221, 2231, 2241, 2251 and connection line electrodes 2411, 2421, 2431, 2441, 2451, and 2461 included in the magnetic resistance element MR1, magnetism-sensing sections 2312, 2322, 2332, 2342, and 2352 and connection line electrodes 2512, 2522, 2532, 2542, 2552, and 2562 included in the magnetic resistance element MR2, a magnetism-sensing section 2311 included in the resistance element R1, and a magnetism-sensing section 2212 included in the resistance element R2.

Magnetism-sensing sections 2211, 2221, 2231, 2241, 2251, 2312, 2322, 2332, 2342, and 2352 included in the magnetic resistance elements MR1 and MR2 each include a semiconductor film made of InSb or the like, and are each formed in a long-length pattern where the length is larger than the width. These magnetism-sensing sections also each include multiple shorting circuits formed at predetermined intervals along the long length thereof and made of a conductive material. The magnetism-sensing sections 2211, 2221, 2231, 2241, 2251, 2312, 2322, 2332, 2342, and 2352 are disposed in such a manner that the long length directions thereof are parallel with the second direction.

The magnetism-sensing section 2211 included in the magnetic resistance element MR1 and a ground connection electrode 2921 are electrically connected via a connection line electrode 2411. Also in the magnetic resistance element MR1, the magnetism-sensing sections 2211 and 2221 are electrically connected via a connection line electrode 2421, the magnetism-sensing sections 2221 and 2231 are electrically connected via a connection line electrode 2431, the magnetism-sensing sections 2231 and 2241 are electrically connected via a connection line electrode 2441, and the magnetism-sensing sections 2241 and 2251 are electrically connected via a connection line electrode 2451. Also, the magnetism-sensing section 2251 included in the magnetic resistance element MR1 and a voltage output electrode 2931 are electrically connected via a connection line electrode 2461.

The magnetism-sensing section 2312 included in the magnetic resistance element MR2 and a voltage input electrode 2912 are electrically connected via a connection line electrode 2512. Also, in the magnetic resistance element MR2, the magnetism-sensing sections 2312 and 2322 are electrically connected via a connection line electrode 2522, the magnetism-sensing sections 2322 and 2332 are electrically connected via a connection line electrode 2532, the magnetism-sensing sections 2332 and 2342 are electrically connected via a connection line electrode 2542, and the magnetism-sensing sections 2342 and 2352 are electrically connected via a connection line electrode 2552. Also, the magnetism-sensing section 2352 included in the magnetic resistance element MR2 and a voltage output electrode 2932 are electrically connected via a connection line electrode 2562.

The magnetism-sensing sections included in the magnetic resistance elements MR1 and MR2 are closely arranged in the following order along a first direction of the formation area of the magnetic detection circuit 20. That is, the magnetism-sensing section 2211 of the magnetic resistance element MR1, the magnetism-sensing sections 2352 and 2342 of the magnetic resistance element MR2, the magnetism-sensing sections 2221 and 2231 of the magnetic resistance element MR1, the magnetism-sensing sections 2332 and 2322 of the magnetic resistance element MR2, the magnetism-sensing sections 2241 and 2251 of the magnetic resistance element MR1, and the magnetism-sensing section 2312 of the magnetic resistance element MR2 are disposed in the presented order from a first end (upper end of Fig. 3(A)) of the formation area in the first direction.

Thus, the magnetism-sensing sections of the magnetic resistance elements MR1 and MR2 are configured in a convoluted manner without the magnetism-sensing sections of each magnetic resistance element being gathered. Also, since the magnetism-sensing sections of the magnetic resistance elements MR1 and MR2 are arranged along the first direction perpendicular to the detection subject transfer direction, the magnetic resistance elements MR1 and MR2 simultaneously react to the passage of a magnetized section provided on the detection subject.

The magnetism-sensing sections 2311 and 2212 included in the resistance elements R1 and R2 each include a semiconductor film made of InSb or the like, and are each formed in a long-length pattern where the length is larger than the width. Unlike the magnetic resistance elements MR1 and MR2, no shorting electrodes are formed on the semiconductor films forming the magnetism-sensing sections 2311 and 2212 of the resistance element R1 and R2 so that the resistance values thereof hardly vary with variations in the magnetic flux density. The magnetism-sensing section 2311 forming the resistance element R1 is disposed outside the formation area of the magnetic resistance elements MR1 and MR2 in such a manner that the magnetism-sensing section 2311 directly connects the voltage input electrode 2911 and voltage output electrode 2931 and in such a manner that the long length direction thereof is parallel with the first direction. The magnetism-sensing section 2212 forming the resistance element R2 is disposed outside the formation area of the magnetic resistance elements MR1 and MR2 in such a manner that the magnetism-sensing section 2212 directly connects the ground connection electrode 2922 and output voltage terminal Vout-B and In such a manner that the long length direction thereof is parallel with the first direction.

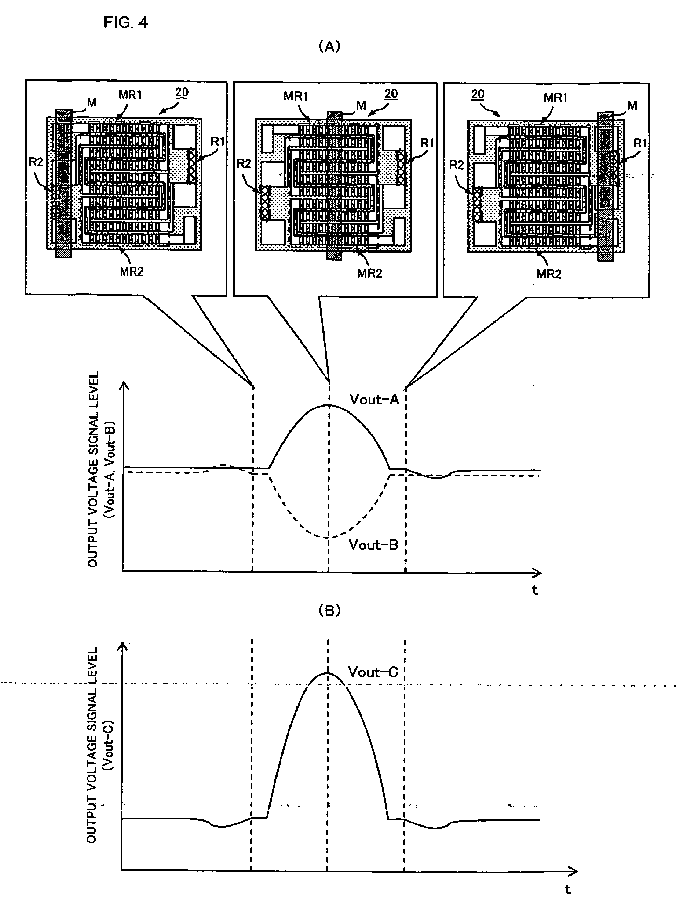

Fig. 4(A) is a diagram showing the waveform and operation of an output voltage signal of the magnetic detection circuit 20 according to this embodiment. Fig. 4(B) is a diagram showing the waveform of an output voltage signal of a magnetic sensor including the magnetic sensor apparatus 20. M in Fig. 4 represents a magnetized section of a detection subject.

By adopting the above-mentioned material and configuration of the magnetism-sensing sections, the magnetic resistance elements MR1 has a characteristic where as the magnetic flux density is increased, the resistance value thereof is increased to a greater extent than that of the resistance element R1. Also, since the magnetic resistance element MR1 is connected to the ground terminal GND, the output voltage signal Vout-A takes a waveform where when the magnetized section M of the detection subject passes by the formation area of the magnetic resistance element MR1, the voltage level increases gradually, then reaches a predetermined peak value, and then decreases gradually on the basis of the voltage division ratio between the magnetic resistance element MR1 and resistance element R1. On the other hand, when the magnetized section passes by the formation area of the resistance element R1, the voltage level decreases slightly

On the other hand, the magnetic resistance element MR2 has a characteristic where as the magnetic flux density is increased, the resistance value thereof is increased to a greater extent than that of the resistance element R2. Also, since the magnetic resistance element MR2 is connected to the voltage input terminal Vin, the output voltage signal Vout-B has a waveform where when the magnetized section M of the detection subject passes by the formation area of the magnetic resistance element MR2, the voltage level decreases gradually, then reaches a predetermined peak value, and then increases gradually on the basis of the voltage division ratio between the magnetic resistance elements MR2 and resistance element R2. On the other hand, when the magnetized section passes by the formation area of the resistance element RZdisposed behind the formation area of the magnetic resistance element MR2 !n the transfer direction, the voltage level decreases slightly.

Since the magnetic resistance elements MR1 and MR2 simultaneously react to variations in the magnetic flux density, the output voltage signal Vout-A and output voltage signal Vout-B also simultaneously make main reactions to the variations in the magnetic flux density.

When the two output voltage signals Vout-A and Vout-B outputted from the magnetic detection circuit 20 are amplified using a differential amplifier circuit connected to the rear of the magnetic detection circuit 20, there is obtained a waveform that has one peak indicating a significant voltage level variation in a portion thereof corresponding to the main reactions of the magnetic resistance elements MR1 and MR2, as shown in Fig. 4(B).

Incidentally, extremely small variations in level of voltages outputted by the resistance elements R1 and R2 occur before and after the peaks of the waveform portions representing the main reactions. However, these level variations are extremely small compared with variations in voltage level due to the main reactions of the magnetic resistance elements MR1 and MR2. Therefore, for example, by setting the threshold for detecting the magnetized section to a measure of high value, the magnetized section is detected accurately on the basis of only the main reactions without detecting reactions that cause such small level variations.

In this embodiment, the magnetism-sensing section of the resistance element R1 and the magnetism-sensing section of the resistance element R2 are formed separately on both sides in the second direction, of the formation areas of the magnetism-sensing sections of the magnetic resistance elements MR1 and MR2. However, both the magnetism-sensing sections of the resistance elements R1 and R2 may be provided on one side of the areas.

Next, a magnetic sensor apparatus according to a third embodiment of the present invention will be described with reference to the drawings.

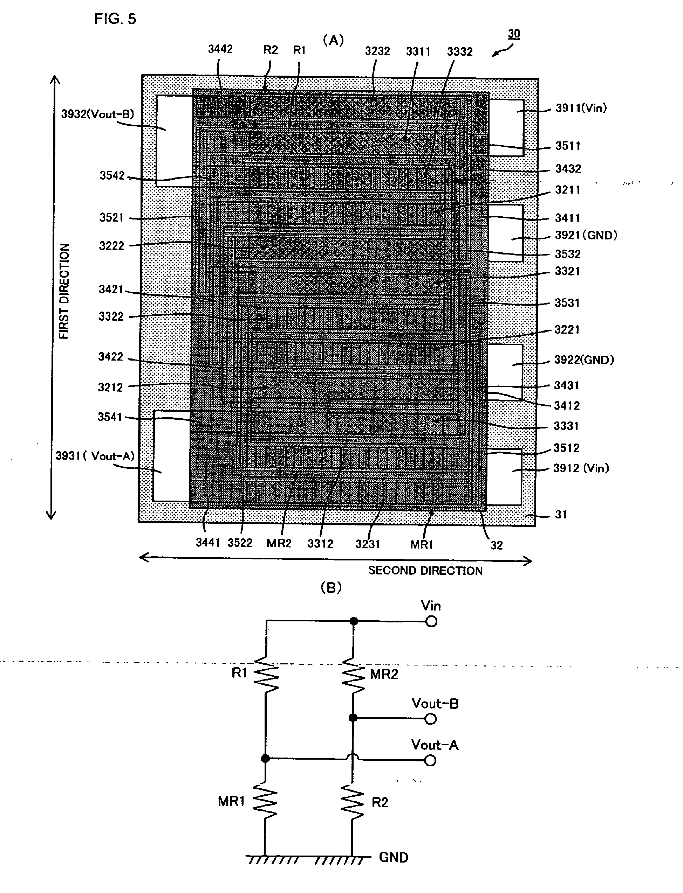

Fig. 5(A) is a plan view showing a configuration of a magnetic detection circuit 30 of the magnetic sensor apparatus according to this embodiment. Fig. 5(B) is an equivalent circuit diagram showing the magnetic detection circuit 30.

While all the connection line electrodes are directly disposed on a surface of the substrate in each of the magnetic detection circuits according to the above-mentioned embodiments, some connection line electrodes of the magnetic detection circuit 30 according to this embodiment are formed on a protection film 32 formed on the upper surfaces of magnetism-sensing sections and the like.

Specifically, the magnetic detection circuits 30 is configured as follows.

Voltage input electrodes 3911 and 3912 and ground connection electrodes 3921 and 3922 are disposed at one end of the formation area of the magnetic detection circuit 30 on a substrate 31 along a second direction (lateral direction in Fig. 5(A)) Voltage output electrodes 3931 and 3932 are disposed at the other end thereof.

Also disposed on the substrate 31 are magnetism-sensing sections 3211, 3221, and 3231 included In the magnetic resistance element MR1, magnetism-sensing sections 3312, 3322, and 3332 included In the magnetic resistance element MR2, magnetism-sensing sections 3311, 3321, and 3331 included in the resistance element R1, and magnetism-sensing sections 3212, 3222, and 3232 included in the resistance element R2.

The magnetism-sensing sections 3211, 3221, 3231, 3312, 3322, and 3332 included in the magnetic resistance elements MR1 and MR2 are each a long-length pattern where the length is larger than the width and are each formed by forming shorting circuits made of a conductive material at predetermined intervals on a semiconductor film along the long length direction thereof. These magnetism-sensing sections are disposed in such a manner that the long length directions thereof are parallel with the second direction.

The magnetism-sensing sections 3311, 3321, 3331, 3212, 3222, and 3232 included in the resistance elements R1 and R2 are each a long-length pattern where the length is larger than the width, include no shorting circuits, and are disposed in such a manner that the long length directions thereof are parallel with the second direction.

The above-mentioned magnetism-sensing sections are closely disposed in such a manner that the magnetic resistance elements including these magnetism-sensing sections change places along the first direction one after another. Specifically, the magnetism-sensing section 3232 of the resistance element R2, the magnetism-sensing section 3311 of the resistance element R1, the magnetism-sensing section 3332 of the magnetic resistance element MR2, the magnetism-sensing section 3211 of the magnetic resistance element MR1, the magnetism-sensing section 3222 of the resistance element R2, the magnetism-sensing section 3321 of the resistance element R1, the magnetism-sensing section 3322 of the magnetic resistance element MR2, the magnetism-sensing section 3221 of the magnetic resistance element MR1, the magnetism-sensing section 3212 of the resistance elements R2, the magnetism-sensing section 3331 of the resistance element R1, the magnetism-sensing section 3312 of the magnetic resistance element MR2, and the magnetism-sensing section 3231 of the magnetic resistance element MR1 are disposed in the presented order from a first end (upper end of Fig. 5(A)) of the formation area of the magnetic detection circuit 30 along the first direction.

Also disposed on the substrate 31 are connection line electrodes 3411, 3412, 3441, 3442, 3511, 3512, 3541, and 3542 for connecting the magnetic resistance elements MR1 and MR2, and the resistance elements R1 and R2, and the voltage input electrodes, voltage output electrodes, and ground connection electrodes.

The connection line electrode 3411 connects the magnetism-sensing section 3211 of the magnetic resistance element MR1 and the ground connection electrode 3921. The connection line electrode 3412 connects the magnetism-sensing section 3212 of the resistance element R2 and the ground connection electrode 3922. The connection line electrode 3441 connects the magnetism-sensing section 3231 of the magnetic resistance element MR1 and the voltage output electrode 3931. The connection line electrode 3442 connects the magnetism-sensing section 3232 of the resistance element R2 and the voltage output electrode 3932. The connection line electrode 3511 connects the magnetism-sensing section 3311 of the resistance element R1 and the voltage input electrode 3911. The connection line electrode 3512 connects the magnetism-sensing section 3312 of the magnetic resistance element MR2 and the voltage input electrode 3912. The connection line electrode 3541 connects the magnetism-sensing section 3331 of the resistance elements R1 and the voltage output electrode 3931. The connection line electrode 3542 connects the magnetism-sensing section 3332 of the magnetic resistance element MR2 and the voltage output electrode 3932.

The insulative protection film 32 is disposed on surfaces of the above-mentioned magnetism-sensing sections and connection line electrodes. Disposed on a surface of the protection film 32 are connection line electrodes 3421, 3431, 3522, 3532, 3521, 3531, 3422 and 3432 for connecting the multiple magnetism-sensing sections included in each of the magnetic resistance elements MR1 and MR2, and the resistance elements R1 and R2.

The connection line electrode 3421 connects the magnetism-sensing sections 3211 and 3221 of the magnetic resistance element MR1. The connection line electrode 3431 connects the magnetism-sensing sections 3221 and 3231 of the magnetic resistance element MR1. The connection line electrode 3522 connects the magnetism-sensing sections 3312 and 3322 of the magnetic resistance element MR2. The connection line electrode 3532 connects the magnetism-sensing sections 3322 and 3332 of the magnetic resistance element MR2. The connection line electrode 3521 connects the magnetism-sensing sections 3311 and 3321 of the resistance element R1. The connection line electrode 3631 connects the magnetism-sensing sections 3321 and 3331 of the resistance element R1. The connection line electrode 3422 connects the magnetism-sensing sections 3212 and 3222 of the resistance element R2. The connection line electrode 3432 connects the magnetism-sensing sections 3222 and 3232 of the resistance element R2. These connection line electrodes are connected to the corresponding magnetism-sensing sections through via holes (not shown) formed on the protection film 32.

By adopting the above-mentioned configuration, the multiple magnetism-sensing sections included in each of the different magnetic resistance elements MR1 and MR2, and resistance element R1 and R2, are disposed in such a manner that these magnetism-sensing sections change places one after another along the first direction. Thus, as in the above-mentioned first embodiment, the magnetic resistance elements MR1, MR2, and resistance elements R1 and R2, simultaneously react to a magnetized section of a detection subject.

By adopting such a configuration, the magnetized section of the detection subject is detected accurately, as in the above-mentioned first embodiment

In the above-mentioned example, an Si substrate is used as a semi-insulating substrate; however, a substrate made of a material other than Si may be used. Also in the above-mentioned example, the magnetism-sensing sections are made of InSb; however, any material may be used as long as the material is a material, the resistance value of which varies due to passage of a magnetic flux.

Also in the above-mentioned example, the MR1 and MR2 having the shorting electrodes in the magnetism-sensing sections thereof and the R1 and R2 having no shorting electrodes in the magnetism-sensing sections thereof are used as magnetic resistance elements of one magnetic detection circuit. However, instead of the R1 and R2, magnetic resistance elements having shortening electrodes in magnetism-sensing sections thereof, which are less sensitive than those of the MR1 and MR2 may be used.

### Reference Numerals

10, 20, 30: magnetic detection circuit
11, 21, 31: substrate
32: protection film
1211, 1221, 1231, 1312, 1322, 1332, 1311, 1321, 1212, 1222: magnetism-sensing section
1411, 1421, 1431, 1441, 1512, 1522, 1532, 1542, 1511, 1521, 1441, 1412, 1422, 1542: connection line electrode
1911, 1912: voltage input electrode
1921, 1922: ground connection electrode
1931, 1932: voltage output electrode
MR1, MR2, R1, R2: magnetic resistance element, and resistance elements.
M: detection subject

## Claims

1. A magnetic sensor apparatus (1) comprising:
a) a plurality of magnetism detection units connected in parallel between a voltage input terminal (Vin) and a ground terminal (GND),
wherein each magnetism detection unit includes a plurality of magnetic resistance elements (MR1, MR2) and resistance elements (R1, R2) In series connected between the voltage input terminal (Vin) and the ground terminal (GND), and
each magnetism detection unit outputs a voltage from an output voltage terminal (Vout-A, Vout-b) connected to a junction of the magnetic resistance elements (MR1, MR2) and resistance elements (R1, R2) as an output voltage, the voltage being obtained due to voltage division performed by the magnetic resistance elements (MR1, MR2) and resistance elements (R1, R2), and
wherein each magnetic resistance element (MR1, MR2) includes a plurality of long-length magnetism-sensing sections (1211, 1221, 1231, 1312, 1322, 1332, 1311, 1321, 1212, 1222) disposed on a surface of a substrate (11), each magnetism-sensing section being a magnetism-sensing section, a resistance value of which varies due to passage of a magnetic flux,
the magnetism-sensing sections having different characteristics with respect to a variation in resistance value due to passage of a magnetic flux, and
wherein the magnetism-sensing sections of all the magnetic resistance elements being arranged side by side in one direction so that at least one magnetism-sensing section included in one magnetic resistance element is not adjacent to any side of each of the plurality of other magnetism-sensing sections included in the magnetic resistance element: and
b) a differential amplifier circuit (100) receiving output signals of the magnetism detection units to perform a differential amplification process; wherein
a plurality of magnetism-sensing sections are included in each of the magnetic resistance elements (MR1, MR2) a resistance value of each of which significantly varies due to passage of a magnetic flux, among the magnetic resistance elements (MR1, MR2) are disposed in such a manner that directions of the long lengths thereof are parallel with one another and in such a manner that at least one magnetism-sensing section included in one of the magnetic resistance elements (MR1, MR2) is not adjacent to any side of each of the plurality of other magnetism-sensing sections included in the sensitive magnetic resistance element, and
one of the magnetic resistance elements (MR1, MR2) is connected between the output voltage terminal and the ground terminal in a first magnetism detection unit of the magnetism detection units, and one of the sensitive magnetic resistance elements is connected between the voltage input terminal and the output voltage terminal in a second magnetism detection unit thereof, wherein a plurality of magnetism-sensing sections included in each of the resistance elements (R1, R2) among the plurality of elements included in the first magnetism detection unit are disposed along with the magnetism-sensing sections of the magnetic resistance elements (MR1, MR2) among the elements included in the first magnetism detection unit in such a manner that at least one magnetism-sensing section included in one of the resistance elements (R1, R2) is not adjacent to any side of each of the plurality of other magnetism-sensing sections included in the resistance element (R1, R2).

2. The magnetic sensor apparatus according to claim 1, wherein the directions of the long lengths of the magnetism-sensing sections are perpendicular to a direction of arrangement of magnetic sections of a detection subject.

## Patentansprüche

1. Magnetische Sensorvorrichtung (1), die Folgendes umfasst:
a) mehrere Magnetismusdetektionseinheiten, die parallel zwischen einem Spannungseingangsanschluss (Vin) und einem Masseanschluss (GND) geschaltet sind,
wobei jede Magnetismusdetektionseinheit mehrere Magnetwiderstandselemente (MR1, MR2) und Widerstandselemente (R1, R2) beinhaltet, die in Serie zwischen dem Spannungseingangsanschluss (Vin) und dem Masseanschluss (GND) geschaltet sind, und
jede Magnetismusdetektionseinheit eine Spannung von einem Ausgangsspannungsanschluss (Vout-A, Vout-b), der mit einem Übergang der Magnetwiderstandselemenete (MR1, MR2) und der Widerstandselemente (R1, R2) verbunden ist, als Ausgangsspannung ausgibt, wobei die Spannung aufgrund einer Spannungsteilung erhalten wird, die von den Magnetwiderstandselementen (MR1, MR2) und den Widerstandselementen (R1, R2) durchgeführt wird, und
wobei jedes Magnetwiderstandselement (MR1, MR2) mehrere Langlängen-Magnetismuserfassungssektionen (1211, 1221, 1231, 1312, 1322, 1332, 1311, 1321, 1212, 1222) aufweist, die auf einer Oberfläche eines Substrats (11) angeordnet sind, wobei jede Magnetismuserfassungssektion eine Magnetismuserfassungssektion ist, von der ein Widerstandswert aufgrund der Passage eines Magnetflusses variiert,
wobei die Magnetismuserfassungssektionen unterschiedliche Charakteristiken mit Bezug auf eine Variation des Widerstandswertes infolge der Passage eines Magnetflusses haben, und
wobei die Magnetismuserfassungssektionen aller Magnetwiderstandselemente Seite an Seite in einer Richtung angeordnet sind, so dass wenigstens eine in einem Magnetwiderstandselement enthaltene Magnetismuserfassungssektion nicht neben einer Seite von jeder der mehreren anderen in dem Magnetwiderstandselement enthaltenen Magnetismuserfassungssektionen liegt; und
b) eine Differentialverstärkerschaltung (100), die Ausgangssignale der Magnetismusdetektionsschaltungen zum Durchführen eines Differentialverstärkungsvorgangs erhält; wobei
mehrere Magnetismuserfassungssektionen in jedem der Magnetwiderstandselemente (MR1, MR2) enthalten sind, von denen jeweils ein Widerstandswert aufgrund der Passage eines Magnetflusses erheblich variiert, unter den magnetischen Widerstandselementen (MR1, MR2) so angeordnet sind dass Richtungen der langen Längen davon parallel zueinander sind, und so, dass wenigstens eine in einem der Magnetwiderstandselemente (MR1, MR2) enthaltene Magnetismuserfassungssektion nicht neben einer Seite von jeder der mehreren in dem empfindlichen Magnetwiderstandselement enthaltenen Magnetismuserfassungssektionen liegt, und
eines der Magnetwiderstandselemente (MR1, MR2) zwischen dem Ausgangsspannungsanschluss und dem Masseanschluss in einer ersten Magnetismusdetektionseinheit der Magnetismusdetektionseinheiten geschaltet ist und eines der empfindlichen Magnetwiderstandselemente zwischen dem Spannungseingangsanschluss und dem Ausgangsspannungsanschluss in einer zweiten Magnetismusdetektionseinheit davon geschaltet ist, wobei mehrere in jedem der Widerstandselemente (R1, R2) enthaltene Magnetismuserfassungssektionen unter den mehreren in der ersten Magnetismusdetektionseinheit enthaltenen Elementen zusammen mit den Magnetismuserfassungssektionen der
Magnetwiderstandselemente (MR1, MR2) unter den in der ersten Magnetismusdetektionseinheit enthaltenen Elementen so angeordnet sind, dass wenigstens eine in einem der Widerstandselemente (R1, R2) enthaltene Magnetismuserfassungssektion nicht neben einer Seite von jeder der mehreren anderen in dem Widerstandselement (R1, R2) enthaltenen Magnetismuserfassungssektionen liegt.

2. Magnetische Sensorvorrichtung nach Anspruch 1, wobei die Richtungen der langen Längen der Magnetismuserfassungssektionen lotrecht zu einer Richtung der Anordnung von magnetischen Sektionen eines Detektionsobjekts sind.

## Revendications

1. Appareil de capteur magnétique (1) comprenant :
a) une pluralité d'unités de détection de magnétisme connectées en parallèle entre une borne d'entrée de tension( Vin) et une borne de masse (GND) ;
dans lequel chaque unité de détection de magnétisme comporte une pluralité d'éléments de résistance magnétique (MR1, MR2) et d'éléments de résistance (R1, R2) connectés en séries entre la borne d'entrée de tension (Vin) et la borne de masse (GND), et
chaque unité de détection de magnétisme produit en sortie une tension depuis une borne de tension de sortie (Vout-A, Vout-b) connectée à une jonction des éléments de résistance magnétique (MR1, MR2) et des éléments de résistance (R1, R2) comme tension de sortie, la tension étant obtenue en raison de la division de tension exécutée par les éléments de résistance magnétiques (MR1, MR2) et les éléments de résistance (R1, R2), et
dans lequel chaque élément de résistance magnétique (MR1, MR2) comporte une pluralité sections de détection de magnétisme dans la longueur longue (1211, 1221, 1231, 1312, 1322, 1332, 1311, 1321, 1212 ,1222) disposées sur une surface d'un substrat (11), chaque section de détection de magnétisme étant une section de détection de magnétisme dont une valeur de résistance varie en raison du passage d'un flux magnétique,
les sections de détection de magnétisme ayant différentes caractéristiques relativement à une variation de la valeur de résistance en raison du passage d'un flux magnétique, et
dans lequel les sections de détection de magnétisme de tous ies éléments de résistance magnétique sont agencées côte à côte dans un même sens de telle sorte qu'au moins une section de détection de magnétisme incluse dans un élément de résistance magnétique ne soit adjacente à aucun côté de chacune de la pluralité d'autres sections de détection de magnétisme incluses dans l'élément de résistance magnétique ; et
b) un circuit d'amplificateur différentiel (100) recevant des signaux de sortie des unités de détection de magnétisme pour exécuter un processus d'amplification différentielle, dans lequel
une pluralité de sections de détection de magnétisme est incluse dans chacun des éléments de résistance magnétique (MR1, MR2) dont une valeur de résistance varie considérablement en raison du passage d'un flux magnétique, lesquelles sont disposées parmi les éléments de résistance magnétique (MR1, MR2) de manière à ce que les sens de leurs longueurs longues soient parallèles les uns aux autres et de manière à ce qu'au moins une section de détection de magnétisme incluse dans l'un des éléments de résistance magnétique (MR1, MR2) ne soit adjacente à aucun côté de chacune de la pluralité d'autres sections de détection de magnétisme incluses dans l'élément de résistance magnétique sensible, et
l'un des éléments de résistance magnétique (MR1, MR2) est connecté entre la borne de tension de sortie et la borne de masse dans une première unité de détection de magnétisme des unités de détection de magnétisme, et l'un des éléments de résistance magnétiques sensibles est connecté entre la borne d'entrée de tension et la borne de tension de sortie dans une seconde unité de détection de magnétisme de celles-ci, une pluralité de sections de détection de magnétisme incluses dans chacun des éléments de résistance (R1, R2) parmi la pluralité d'éléments inclus dans la première unité de détection de magnétisme étant disposée avec les sections de détection de magnétisme des éléments de résistance magnétique (MR1, MR2) parmi les éléments inclus dans la première unité de détection de magnétisme de manière à ce qu'au moins une section de détection de magnétisme incluse dans l'un des éléments de résistance (R1, R2) ne soit adjacente à aucun côté de chacune de la pluralité d'autres sections de détection de magnétisme incluses dans l'élément de résistance (R1, R2).

2. Appareil de capteur magnétique selon la revendication 1, dans lequel les sens des longueurs longues des sections de détection de magnétisme sont perpendiculaires à un sens d'agencement des sections magnétiques d'un sujet de détection.
